# EUROPÄISCHE PATENTSCHRIFT

(11) **EP 0 761 838 B1**
(45) Veröffentlichungstag und Bekanntmachung des Hinweises auf die Patenterteilung: **08.08.2001**
(21) Anmeldenummer: 96109735.9
(22) Anmeldetag: 18.06.1996
(51) Int. Cl.: C23C 14/34, C04B 35/00

(54) **Target für die Kathodenzerstäubung und Verfahren zur Herstellung eines solchen Targets**
Sputtering target and method for its manufacturing
Cible pour pulvérisation cathodique et son procédé de fabrication

(30) Priorität: 18.08.1995 DE 19530364; 30.10.1995 DE 19540379
(43) Veröffentlichungstag der Anmeldung: 12.03.1997
(73) Patentinhaber: W.C. Heraeus GmbH & Co. KG, 63450 Hanau (DE)
(72) Erfinder: Goy, Karl-Heinz, 63571 Gelnhausen (DE); Lupton, David Francis, Dr., 63571 Gelnhausen (DE); Schielke, Jörg, 63486 Bruchköbel (DE); Schölz, Friedhold, 63517 Rodenbach (DE); Serole, Bernard, 26380 Peyrins (FR); Bohmeier, Hans, Dr., 09599 Freiberg (DE)
(74) Vertreter: Kühn, Hans-Christian

(56) Entgegenhaltungen:
- DE-C- 4 407 774
- US-A- 5 435 826
- PATENT ABSTRACTS OF JAPAN vol. 014, no. 382 (C-0749), 17.August 1990 & JP-A-02 141459 (MITSUBISHI METAL CORP), 30.Mai 1990,
- PATENT ABSTRACTS OF JAPAN vol. 012, no. 482 (C-553), 15.Dezember 1988 & JP-A-63 199862 (ASAHI GLASS CO LTD), 18.August 1988,
- PATENT ABSTRACTS OF JAPAN vol. 017, no. 678 (C-1141), 13.Dezember 1993 & JP-A-05 222526 (ASAHI GLASS CO LTD), 31.August 1993,

## Beschreibung

Die Erfindung betrifft ein Target für die Kathodenzerstäubung auf Basis von heißgepreßtem oder isostatisch heißgepreßtem Indiumoxid/Zinnoxid-Pulver mit einer Dichte von mindestens 95 % seiner theoretischen Dichte, und mit einem unterstöchiometrischen Sauerstoffgehalt.

Derartige Targets werden beispielsweise für die Herstellung dünner Schichten aus Indium-Zinn-Oxid eingesetzt. Diese sogenannten ITO-Schichten zeichnen sich durch ihre Lichtdurchlässigkeit und durch ihre elektrische Leitfähigkeit aus. Sie werden beispielsweise für die Herstellung von Flüssigkristallanzeigen verwendet. Am besten bewährt hat sich eine Zusammensetzung der ITO-Schichten, die etwa 90 Gewichts-% Indiumoxid und etwa 10 Gewichts-% Zinnoxid enthält.

Ein gattungsgemäßes Target ist aus der DE-C1 44 07 774 bekannt. In der oxidkeramischen Matrix des Targets sind metallische Phasenteile mit Größen von unterhalb 50 µm gleichmäßig verteilt eingelagert. Das Target weist eine Dichte von mehr als 96 % der theoretischen Dichte des entsprechenden volloxidischen Materials auf.

Aus US 5,435,826 ist ein Target mit einer relativen Dichte von 90% und höher zur Herstellung von Indium-Zinn-Oxid-Schichten bekannt. Das Target wird durch Pressen einer Pulvermischung aus Indiumoxid und Zinnoxid mit einer mittleren Korngröße von 0,1 µm oder darunter und einem Zinngehalt von 1,5 bis 6 Gew.-% hergestellt.

Der Erfindung liegt die Aufgabe zugrunde, ein Target anzugeben, das sich durch hohe Festigkeit und gleichzeitig hohe Sputterrate auszeichnet.

Weiterhin betrifft die Erfindung ein Verfahren zur Herstellung eines Targets für die Kathodenzerstäubung durch Bereitstellen eines Indiumoxid/Zinnoxid-Ausgangspulvers und Verdichten des Ausgangspulvers durch Heißpressen oder isostatisches Heißpressen. Auch ein derartiges Verfahren ist aus der DE-C1 44 07 774 bekannt. Es wird vorgeschlagen, Pulver aus Indiumoxid und Zinnoxid unter reduzierender Atmosphäre zu glühen, um einen Reduktionsgrad von ca. 0,02 bis 0,2 einzustellen. Der Reduktionsgrad ist dabei definiert als der Sauerstoffverlust während der genannten Reduktionsbehandlung im Verhältnis zum Sauerstoffgehalt des volloxidischen Pulvers. Durch die Reduktionsbehandlung wurde Pulver mit kugelförmigen, 1 bis 10 µm großen Metallphasen erzeugt, deren Zinngehalt über 90 Gewichts-% liegt. Das so hergestellte Pulver wird in einem Zylinder vorgepresst und dann in einer Stahlkanne bei ca. 800 °C und einem Druck von 200 MPa heißisostatisch kompaktiert.

Die vorgeschlagene Verfahrensweise ist relativ arbeitsaufwendig. Die Behandlung unter reduzierender Atmosphäre erfordert die Bereitstellung geeigneter Reduktionsmittel, beispielsweise von Formiergas, und ist daher auch verhältnismäßig kostenaufwendig. Die exakte Einstellung des Sauerstoffgehaltes erfordert große Sorgfalt. Problematisch ist insbesondere auch die Einstellung eines gleichmäßigen Reduktionsgrades über das gesamte Target-Volumen sowie der hohe Zinngehalt der metallischen Phase.

Der Erfindung liegt daher weiterhin die Aufgabe zugrunde, ein einfaches und kostengünstiges Verfahren zur Herstellung eines Targets anzugeben, das eine definierte Einstellung des Sauerstoffgehaltes und eine homogene chemische Zusammensetzung über das gesamte Target-Volumen erlaubt.

Hinsichtlich des Targets wird die oben genannte Aufgabe ausgehend von dem eingangs genannten Target erfindungsgemäß dadurch gelöst, daß das Target eine Kristallphase aufweist, die mit einem Gewichtsanteil von mindestens 90 %, vorzugsweise mindestens 97 % als Mischkristall von Indiumoxid und Zinnoxid ausgebildet ist, und die eine mittlere Korngröße zwischen 2 µm und 20 µm aufweist.

Es hat sich herausgestellt, daß bei gröberem Korn als 20 µm das Sputtertarget spröde wird und daß bei feinerem Korn als 2 µm die erreichbare Sputtergeschwindigkeit gering ist. Dadurch, daß die Oxidpartikel als Mischkristall vorliegen, wird eine besonders homogene Verteilung von Indium und Zinn gewährleistet. Dies erleichtert die Herstellung gleichmäßiger, homogener ITO-Schichten aus dem erfindungsgemäßen Target. Weiterhin fördert das homogene, im wesentlichen einphasige Kristallgefüge die Bruchfestigkeit des Targets. Zudem ermöglicht die einphasige Mischkristallstruktur die Herstellung von ITO-Schichten mit einer hohen elektrischen Leitfähigkeit. Diese günstigen Effekte wirken sich umso stärker aus, je höher der Anteil an Mischkristallphase im Target ist. Die Effekte erweisen sich aber erst ab einem Mindestanteil von 90 Gew.-% als beachtlich.

Als besonders vorteilhaft hat sich ein Target erwiesen, bei dem die Mischkristallphase durch Heißpressen oder isostatisches Heißpressen von Indiumoxid/Zinnoxid-Pulverteilchen hergestellt ist, die einen von außen nach innen abnehmenden Sauerstoffgehalt aufweisen. Der Sauerstoffgehalt kann dabei kontinuierlich abnehmen oder die Pulverteilchen können eine oxidische Außenhaut aufweisen, die einen metallischen Kern umschließt. Derartige Pulverteilchen lassen sich besonders leicht dichtsintern. Dabei wird eine Ausführungsform des Targets bevorzugt, bei der Mischkristall in der Gitterstruktur des Indiumoxids vorliegt.

Eine geeignete Mischkristallphase ist in der älteren deutschen Patentanmeldung DE 44 27 060, auf die hiermit ausdrücklich Bezug genommen wird, insbesondere anhand von pulverdiffraktometrischen Beugungsmessungen näher charakterisiert.

Vorteilhafterwise weisen die Pulverteilchen eine metallische Phase auf, deren Indiumgehalt mindestens 50 Gew.-% beträgt. Damit überwiegt in der metallischen Phase der Indiumanteil gegenüber dem Zinnanteil. Dies ist auch bei den üblichen ITO-Zusammensetzungen, beispielsweise bei einem Mischungsverhältnis von Indiumoxid:Zinnoxid von 90:10, der Fall. Gegenüber den aus dem Stand der Technik bekannten Targets mit einer zinnreichen metallischen Phase zeichnen sich die Pulverteilchen mit einer derartigen indiumreichen metallischen Phase daher vorallem dadurch aus, daß ihre chemische Zusammensetzung derjenigen der oxidischen Phase mehr entspricht. Dies gewährleistet eine homogene Verteilung von Zinn und Indium über das gesamte Volumen des Targets.

In einer bevorzugten Ausführungsform des erfindungsgemäßen Targets liegt die chemische Zusammensetzung der indiumreichen metallischen Phase - abgesehen vom Sauerstoffgehalt - möglichst nahe bei derjenigen der Kristallphase. Dies ist beispielsweise bei einer Zusammensetzung der Kristallphase mit Indiumoxid:Zinnoxid von 90:10, bei einem Indiumanteil in der metallischen Phase zwischen 50 Gew.-% und 90 Gew.-% der Fall.

Hinsichtlich des Verfahrens wird die oben genannte Aufgabe ausgehend von dem eingangs genannten Verfahren erfindungsgemäß dadurch gelöst, daß das Ausgangspulver durch Oxidation von fein verteiltem Indium-Zinn-Metall erzeugt wird und daß das Ausgangspulver eine mittlere Teilchengröße im Bereich von 2µm bis 20µm aufweist. Bei dem erfindungsgemäßen Verfahren wird fein verteiltes Metall entsprechend der gewünschten Zusammensetzung an Indium und Zinn erzeugt und anschließend oxidiert. Da im Metall Indium und Zinn entsprechend dem einzustellenden Konzentrationsverhältnis gleichmäßig verteilt sind, weist auch das daraus hergestellte Ausgangspulver eine homogene Zusammensetzung auf.
Das Dichtsintern wird vereinfacht, wenn das Ausgangspulver eine mittlere Teilchengröße im Bereich von 2 µm bis 20 µm aufweist. Durch ein derartiges feinteiliges Ausgangspulver wird eine ebenso feinteilige und gleichmäßige Verteilung des Sauerstoffs und der vorhandenen metallischen Phase im gesamten Targetvolumen erreicht. Im Hinblick hierauf ist es auch besonders vorteilhaft, ein Ausgangspulver mit einer möglichst engen Teilchengrößenverteilung einzusetzen. Bewährt haben sich Ausgangspulver, bei denen die Größe von 90 % der Pulverteilchen um maximal 50 % von der mittleren Teilchengröße abweicht.

Der Sauerstoffgehalt des Ausgangspulvers läßt sich durch den Grad der Oxidationsbehandlung sehr leicht variieren und definiert einstellen. So können Ausgangspulver sowohl mit stöchiometrischem als auch mit unterstöchiometrischem Sauerstoffgehalt erhalten werden. Eine nachträgliche Oxidations- oder Reduktionsbehandlung des Targets beim Sintern kann daher bei dem erfindungsgemäßen Verfahren entfallen. Das erfindungsgemäße Verfahren zielt jedoch nicht ausdrücklich und ausschließlich auf die Vermeidung einer nachträglichen Oxidations- oder Reduktionsbehandlung ab. In Fällen, bei denen eine derartige Nachbehandlung zusätzlich geeignet erscheint, wird diese durch den Einsatz der in ihrem Oxidationsgrad voreingestellten Ausgangspulver aber in jedem Fall erleichtert.

Das erfindungsgemäße Verfahren erlaubt weiterhin eine definierte Einstellung des Sauerstoffgehaltes über das gesamte Target-Volumen. Der Sauerstoffgehalt der einzelnen Pulverteilchen läßt sich definiert einstellen. Bei einem feinteiligen Pulver läßt sich durch geeignete Verteilung des Pulvers ein beliebige Sauerstoff-Verteilung im Target erreichen. Soll beispielsweise der Sauerstoffgehalt - makroskopisch gesehen - im Target-Volumen konstant sein, so wird ein Ausgangspulver mit jeweils gleichem Sauerstoffgehalt in den Pulverteilchen verdichtet. Üblicherweise wird aus dem Ausgangspulver ein größerer Block gesintert, aus dem dann mehrere Targets hergestellt werden können.

Bevorzugt wird ein Verfahren, bei dem das Ausgangspulver durch Zerstäuben einert Indium-Zinn-Metallschmelze unter oxidierenden Bedingungen erzeugt wird. Bei diesem Verfahren, das im folgenden als Kooxidation bezeichnet wird, wird eine Indium-Zinn-Schmelze fein zerstäubt und in einer sauerstoffhaltigen Atmosphäre verbrannt. Hierfür genügt der in der Luftatmosphäre vorhandene Sauerstoff; die Luft kann aber auch mit Sauerstoff angereichert werden. Auf diese Weise fällt üblicherweise ein Mischkristallpulver an, das nicht volloxidiert ist und in dem unterstöchiometrisches Oxid oder metallische Phase vorliegen kann. Bei dem so hergestellten Ausgangspulver können die Pulverteilchen außen einen höheren Sauerstoffgehalt aufweisen als innen. Dies kann soweit gehen, daß die Pulverteilchen außen oxidiert sind und innen eine metallische Phase aufweisen. Die metallische Phase ist in einem solchen Mischkristallpulver besonders gleichmäßig verteilt.

Besonders bewährt hat sich der Einsatz eines Ausgangspulvers mit unterstöchiometrischem Sauerstoffgehalt. Ein derartiges Pulver läßt sich ohne weitere reduzierende Behandlung durch Heißpressen oder durch heißisostatisches Pressen weiterverarbeiten. Eine aufwendige nachträglichen Reduktionsbehandlung des Targets beim Sintern kann daher bei dem erfindungsgemäßen Verfahren entfallen. Es hat sich gezeigt, daß die nicht vollständig oxidierten Ausgangspulver eine genaue Einhaltung der Reduktions- bzw. Oxididationsbedingungen während des Heißpressens bzw. während des isostatischen Heißpressens nicht erfordern, sondern daß hierbei ein gewisser Spielraum gegeben ist. Dabei kann der Sauerstoffgehalt des Ausgangspulvers so niedrig sein, daß in den daraus hergestellten Targets metallisches Indium und/oder Zinn in feinverteilter Form vorliegt.

Der Sauerstoffgehalt des Ausgangspulvers wird mittels des sogenannten " Heißextraktions-Verfahrens" ermittelt. Dabei wird eine genau abgewogene Menge des Ausgangspulvers bzw. eines pulverisierten Targetmaterials in einem Grafittiegel erhitzt und der dabei in Form von Kohlenmonoxid oder Kohlendioxid freigesetzte Sauerstoff gemessen.

Als besonders vorteilhaft hat sich ein Verfahren erwiesen, bei dem die Pulverteilchen des Ausgangspulvers einen von außen nach innen abnehmenden Sauerstoffgehalt aufweisen. Dabei kann der Sauerstoffgehalt kontinuierlich abnehmen, oder die Pulverteilchen können eine oxidische Hülle aufweisen, die einen Kern aus metallischer Phase umgibt. In jedem Fall fällt metallische Phase oder unterstöchiometrisches Oxid in jedem einzelnen Pulverteilchen gleichermaßen an. Infolgedessen ist in den aus den Pulverteilchen hergestellten Preßlingen der vorhandene Sauerstoff gleichmäßig verteilt.

Es hat sich gezeigt, daß derartige Ausgangspulver auf Änderungen der Sinteratmosphäre relativ unempfindlich reagieren und sich besonders leicht dichtsintern lassen. Es kann angenommen werden, daß die oxidische Hülle eine weitere Aufoxidation der Pulverteilchen verhindert oder verlangsamt, so daß dadurch das Sintern der Pulverteilchen beispielsweise an Luft ermöglicht wird, ohne den vorab eingestellten Oxidationsgrad der Pulverteilchen bzw. des Targets wesentlich zu beeinflussen. Aus dem Ausgangspulver kann beim Sintern eine flüssige metallische Phase entstehen, die nach dem Sintern im Target jede beliebige Konfiguration einnehmen kann. Das erfindungsgemäße Verfahren erleichtert aber in jedem Fall eine gleichmäßige Verteilung einer derartigen metallischen Phase.

Als besonders günstig hat sich eine Verfahrensweise erwiesen, bei der ein Ausgangspulver eingesetzt wird, das eine metallische Phase aufweist, deren Indiumgehalt mindestens 50 Gew.-%, beträgt. Bei diesem Ausgangspulver überwiegt in der metallischen Phase der Indiumanteil gegenüber dem Zinnanteil. Dies ist auch bei den üblichen ITO-Zusammensetzungen, beispielsweise bei einem Mischungsverhältnis von Indiumoxid:Zinnoxid von 90:10, der Fall. Gegenüber den aus dem Stand der Technik bekannten Targets mit einer zinnreichen metallischen Phase zeichnen sich die Pulverteilchen mit einer derartigen indiumreichen metallischen Phase daher vorallem dadurch aus, daß ihre chemische Zusammensetzung mehr derjenigen der oxidischen Phase angenähert ist oder dieser sogar entspricht. Dies gewährleistet eine homogene Verteilung von Zinn und Indium über das gesamte Volumen des Targets, und zwar auch in der metallischen Phase, entsprechend dem vorgegebenen Indiumoxid-Zinnoxid-Konzentrationsverhältnis. Dies kann durch das oben genannte "Kooxidationsverfahren" erreicht werden. Denn bei der Verdüsung einer Indium-Zinn-Metallschmelze stellt sich üblicherweise kein chemisches Gleichgewicht ein, so daß die Zusammensetzung der im Pulver erhaltenen metallischen Phase eher derjenigen der Metallschmelze entspricht und nicht zwangsläufig derjenigen, die aufgrund der Thermodynamik im Gleichgewicht zu erwarten wäre.

In einer bevorzugten Ausführungsform des erfindungsgemäßen Verfahrens liegt die chemische Zusammensetzung der indiumreichen metallischen Phase - abgesehen vom Sauerstoffgehalt - möglichst nahe bei derjenigen der Kristallphase. Dies ist beispielsweise bei einer Zusammensetzung der Kristallphase mit Indiumoxid:Zinnoxid von 90:10, bei einem Indiumanteil in der metallischen Phase zwischen 50 Gew.-% und 90 Gew.-% der Fall.

Als besonders vorteilhaft hat sich ein Verfahren erwiesen, bei dem das Target aus einem Ausgangspulver hergestellt wird, dessen Anteile an Mischkristallphase im Kristallgitter von Indiumoxid vorliegen. Dadurch wird eine besonders homogene Verteilung von Indium und Zinn gewährleistet, was die Herstellung gleichmäßiger, homogener ITO-Schichten aus dem erfindungsgemäßen Target erleichtert. Das homogene, im wesentlichen einphasige Kristallgefüge erhöht auch die Bruchfestigkeit des Targets. Diese günstigen Effekte wirken sich um so stärker aus, je höher der Anteil an Mischkristallphase im Target ist. Die Effekte wurden erst ab einem Mindestanteil von ca. 90 Gewichts-% beobachtet. Die Mischkristallphase wird besonders einfach durch das oben beschriebene Kooxidationsverfahren erhalten.

Das Heißpressen bzw. das isostatische Heißpressen des Ausgangspulvers erfolgt vorzugsweise bei niedrigen Temperaturen zwischen 800 °C und 1.050 °C. Bei diesen Temperaturen erfolgt ein Dichtsintern des Ausgangspulvers. Bei höheren Sintertemperaturen besteht die Gefahr, daß sich Zinn-Oxid aus der Mischkristallphase wieder ausscheidet. Andererseits ist es für die Erzielung hoher Dichten günstig, bei möglichst hohen Temperaturen zu sintern. Diese Sintertemperaturen ermöglichen eine wirtschaftliche Verfahrensweise. Niedrigere Sintertemperaturen können jedoch bekanntermaßen durch längere Sinterzeiten ausgeglichen werden und umgekehrt. Die angegebenen Sintertemperaturen sind insofern nur als Richtwerte anzusehen, da gleiche Sinterergebnisse auch beispielsweise bei niedrigeren Sintertemperaturen, aber entsprechend längeren Sinterzeiten erzielbar sind.

Nachfolgend werden das erfindungsgemäße Target und die erfindungsgemäße Herstellung eines solchen Targets anhand von Ausführungsbeispielen und anhand der Zeichnung näher erläutert.

In der Zeichnung zeigen im einzelnen
- **Figur 1**: eine Differential-Thermoanalyse (DTA) von oxidischem und nachträglich unter Formiergas reduziertem Indium- Zinn-Mischkristallpulver,
- **Figur 2**: eine Differential-Thermoanalyse (DTA) von nicht voll oxidiertem Indium-Zinn-Mischkristallpulver.

### 1. Variante des Pulver-Herstellungsverfahrens

Für die Herstellung des Ausgangspulvers wurde eine metallische Schmelze aus Indium und Zinn hergestellt. Der Indium-Anteil bzw. der Zinn-Anteil der Schmelze wurde so eingestellt, daß, bezogen auf die Oxide ein Gewichtsanteil von 90 Gewichts-% Indiumoxid und 10 Gewichts-% Zinnoxid erhalten wird. Die Schmelze wurde verdüst und dabei unter einer Atmosphäre aus 80 Vol.-% Sauerstoff und 20 Vol.-% Luft teilweise oxidiert.

Das so hergestellte ITO-Ausgangspulver fällt mit einem Gewichtsanteil von ca. 97 % als oxidischer Mischkristall an, der noch metallische Phase enthält. Der oxidische Teil des Pulvers zeigt eine einphasige Röntgenstruktur, nämlich die von Indium-Oxid, es weist einen unterstöchiometrischen Sauerstoffgehalt von 17,2 % auf (der stöchiometrische Sauerstoffgehalt liegt bei ca. 17,4 %). In der metallischen Phase aus Indium und Zinn überwiegt der Indium-Anteil.

Die Pulverteilchen weisen untereinander in etwa den gleichen Oxidationsgrad auf, wobei aber die metallische Phase im Innern der einzelnen Pulverteilchen angereichert sein kann. Der Sauerstoffgehalt von ca. 17,2 Gew-% entspricht einem unterstöchiometrischen Sauerstoffgehalt. Bei einem reinen Oxidgemisch dieser Zusammensetzung liegt der stöchiometrische Sauerstoffgehalt bei 17,7 Gew-% und bei Mischkristallen dieser Zusammensetzung um 17,4 Gew-%.

Das so hergestellte Pulver weist eine mittlere Korngröße von ca. 3 µm auf und hat eine nach dem BET-Verfahren gemessene spezifische Oberfläche von ca. 0,3 m²/g.

### 1. Ausführungsbeispiel für die Target-Herstellung:

Das wie oben beschrieben hergestellte Ausgangspulver wurde bei ca. 400 °C unter Vakuum getrocknet, danach in eine Metallkapsel eingeschlossen und evakuiert und anschließend bei einem Druck von 1.050 bar und einer Temperatur von 970 °C über einen Zeitraum von 3 Stunden heißisostatisch verpreßt.

Der so hergestellte Preßling weist eine Dichte von 98 % der theoretischen Dichte auf. Es waren keinerlei Risse und Abplatzungen zu sehen. Die mittlere Korngröße der kristallinen Phase liegt bei 5 µm. Aus dem Preßling konnten leicht mehrere Targets herausgesägt werden.

### Vergleichsbeispiel:

Es wurde ein Ausgangspulver wie eingangs erläutert hergestellt und an Luft 5 Stunden lang bei 850 °C nachoxidiert. Nach der Sauerstoffbehandlung wies das Ausgangspulver einen Sauerstoffgehalt von etwa 17,4 % auf. Anhand pulverdiffraktometrischer Messungen wurde gefunden, daß hierbei ca. 75 % des Zinns im oxidischen Mischkristall vorlagen und dieser einen stöchiometrischen Sauerstoffgehalt aufwies. Daraus läßt sich ermitteln, daß für das so behandelte Mischkristallpulver der Sauerstoffgehalt von 17,4 % dem stöchiometrischen Sauerstoffgehalt entspricht.

Das so nachoxidierte Ausgangspulver wurde bei einem Druck von 1.050 bar und einer Temperatur von 950 °C über einen Zeitraum von 3 Stunden heißisostatisch verpreßt.

Es konnte lediglich ein Preßling mit einer Dichte von 65 % der theoretischen Dichte erzeugt werden, bei dem Risse und Abplatzungen zu erkennen waren.

### 2. Ausführungsbeispiel für die Target-Herstellung:

Das wie oben beschrieben hergestellte Ausgangspulver wurde bei 550 °C evakuiert und dabei entgast und anschließend bei einem Druck von 1.050 bar und einer Temperatur von 970 °C über einen Zeitraum von 3 Stunden heißisostatisch verpreßt. Bei dieser Nachbehandlung des Pulvers wurden somit stark oxidierende Bedingungen vermieden. Der so hergestellte Preßling wies eine Dichte von 98 % der theoretischen Dichte auf. Es waren keinerlei Risse oder Abplatzungen zu sehen Ein ähnliches Ergebnis wurde erhalten, bei einer Nachbehandlung des Ausgangspulvers unter leicht reduzierenden Bedingungen.

### 3. Ausführungsbeispiel für die Target-Herstellung:

Ein entsprechend dem 1. Herstellungsverfahren hergestelltes Pulver wurde ohne eine weitere Vorbehandlung bei einem Druck von 1.050 bar und einer Temperatur von 970°C über einen Zeitraum von zwei Stunden heißisostatisch verpreßt.

Aus dem so hergestellten ITO-Block wurde eine Probe entnommen und röntgendiffraktometrisch sowie auf den Sauerstoffgehalt hin untersucht. Die Diffraktometermessung ergab eine einphasige Röntgenstruktur im Gitter von Indiumoxid. Der Sauerstoffgehalt lag weiterhin bei 17,2 %.

### 2. Variante des Pulver-Herstellungsverfahrens:

Für die Herstellung des Ausgangspulvers wurde eine metallische Schmelze aus Indium und Zinn hergestellt. Der Indium-Anteil bzw. der Zinn-Anteil der Schmelze wurde so eingestellt, daß, bezogen auf die Oxide ein Gewichtsanteil von 90 Gewichts-% Indiumoxid und 10 Gewichts-% Zinnoxid erhalten wird. Die Schmelze wurde verdüst und dabei unter einer Atmosphäre aus 70 Vol.-% Sauerstoff und 30 Vol.-% Luft teilweise oxidiert.

Das so hergestellte ITO-Ausgangspulver fällt mit einem Gewichtsanteil von ca. 97 % als oxidischer Mischkristall an, der noch metallische Phase enthält. Der oxidische Teil des Pulvers zeigt eine einphasige Röntgenstruktur, nämlich die von Indium-Oxid, es weist einen unterstöchiometrischen Sauerstoffgehalt von 16,8 % auf. Bei einem reinen Oxidgemisch dieser Zusammensetzung liegt der stöchiometrische Sauerstoffgehalt bei 17,7 Gew-% und bei Mischkristallen dieser Zusammensetzung um 17,4 Gew-%. In der metallischen Phase aus Indium und Zinn überwiegt der Indium-Anteil. Die Pulverteilchen weisen untereinander in etwa den gleichen Oxidationsgrad auf, wobei aber die metallische Phase im Innern der einzelnen Pulverteilchen angereichert sein kann.

Das so hergestellte Pulver weist eine mittlere Korngröße von ca. 3 µm auf und hat eine nach dem BET-Verfahren gemessene spezifische Oberfläche von ca. 0,3 m²/g.

### 4. Ausführungsbeispiel für die Target-Herstellung:

Ein nach der 2. Variante des Pulver-Herstellungsverfahrens hergestelltes Pulver wurde ohne jegliche weitere Behandlung bei einem Druck von 1.050 bar und bei einer Temperatur von 970°C über einen Zeitraum von drei Stunden heißisostatisch verpreßt.

Der so hergestellte blockartige Preßling wies eine Dichte von 98 % der theoretischen Dichte auf. Es waren nur sehr wenige Risse und Abplatzungen erkennbar, die sich zudem auf den Randbereich begrenzten. Der Block konnte ohne Probleme in mehrere Targets geschnitten werden.

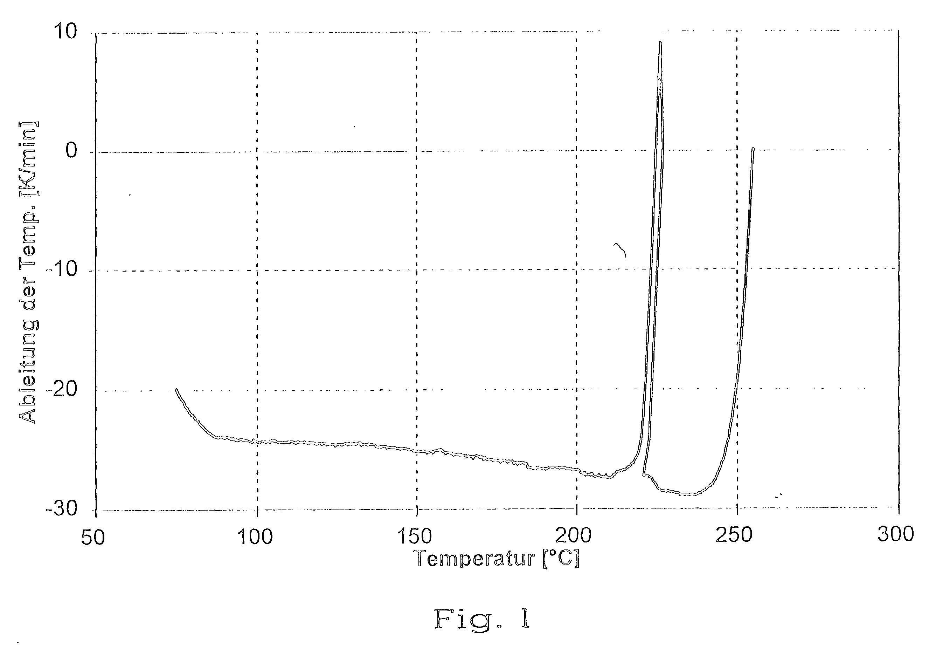

In **Figur 1** ist eine Meßkurve einer Differential-Thermoanalyse (DTA) von einem Indium-Zinnoxid-Mischkristallpulver (ITO-Pulver) mit der oben genannten Zusammensetzung 90:10 dargestellt. Das Pulver wurde ausgehend von einem Oxid mit stöchiometrischem Sauerstoffgehalt nachträglich unter Formiergas (95 % Ar, 5 % H₂) teilreduziert. Insoweit entspricht die Reduktionsbehandlung dem Nachreduzieren des Pulvers beim Sintern des Targets, wie dies bei dem eingangs genannten Verfahren nach dem Stand der Technik bekannt ist. Der Sauerstoffgehalt des Pulvers beträgt etwa 16,8 Gew.-%.

Die DTA-Kurve zeigt eine deutliche Phasenumwandlung bei einer Temperatur um 220 °C. Diese Phasenumwandlung ist gemäß dem In-Sn- Zustandsdiagramm eindeutig mit dem Schmelzpunkt einer metallischen Indium-Zinn-Legierung korrelierbar, deren Zinngehalt ca. 90 % beträgt. Es zeigt sich somit, daß bei einer nachträglichen Reduktionsbehandlung von oxidischem ITO-Pulver der oben genannten Zusammensetzung in erster Linie Zinn - und nicht etwa Indium - reduziert und dabei eine zinnreiche metallische Phase erzeugt wird.

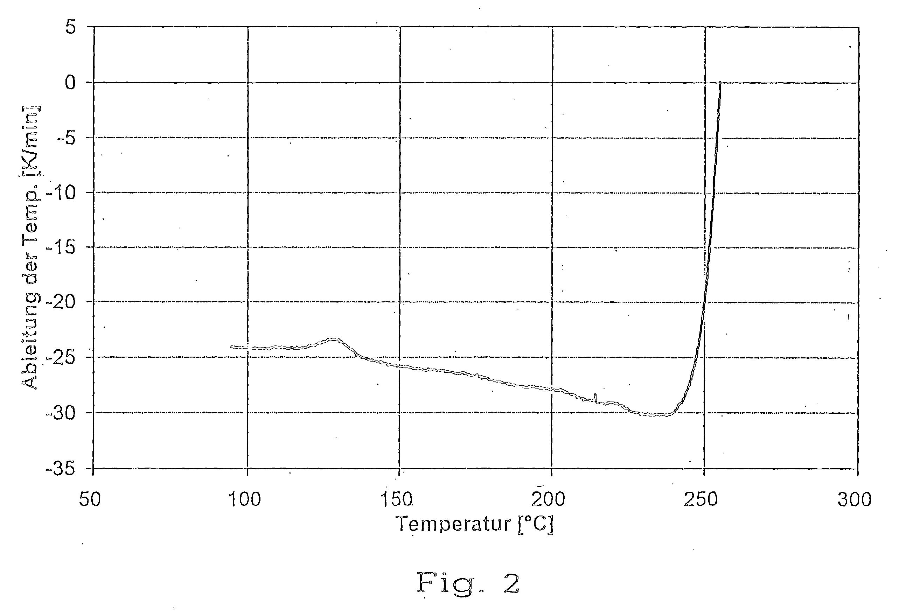

In **Figur 2** ist eine Meßkurve einer Differential-Thermoanalyse eines durch "Kooxidation" hergestellten Ausgangspulvers dargestellt. Bei dem Pulver handelt es ebenfalls um Indium-Zinnoxid-Mischkristallpulver (ITO-Pulver) mit der Zusammensetzung 90:10, das nach dem eingangs erläuterten Verfahren (2. Variante des Pulver-Herstellungsverfahren) hergestellt worden ist und das einen Sauerstoffgehalt von 16,8 Gew.-% aufweist.

Die DTA-Kurve dieses Pulvers unterscheidet sich grundlegend von derjenigen des nachreduzierten Pulvers gemäß Figur 1. Es ist eine Phasenumwandlung bei einer Temperatur von ca. 120 °C erkennbar. Diese Temperatur entspricht in etwa der Schmelztemperatur des InSn-Eutektikums, das bei einer Zusammensetzung von ca. 51 Gew.-% Indium und 49 Gew.-% Zinn liegt. Aus der Breite des Temperaturbereiches über den die Phasenumwandlung erkennbar ist, kann geschlossen werden, daß das ITO-Pulver in diesem Fall eine indiumreiche, metallische Phase aufweist, deren Indium-Anteil bis zu 80 % betragen kann. Es ist einleuchtend, daß eine derartige Zusammensetzung der metallischen Phase an die Zusammensetzung der oxidischen Phase wesentlich besser angepaßt ist, als die Zusammensetzung der metallischen Phase bei dem nachreduzierten Pulver. Daher sind bei einem aus diesem Pulver hergestellten Target die einzelnen chemischen Bestandteile homogener über das Volumen des Targets verteilt.

## Patentansprüche

1. Target für die Kathodenzerstäubung auf Basis von heißgepreßtem oder isostatisch heißgepreßtem Indiumoxid/Zinnoxid-Pulver mit einer Dichte von mindestens 95 % seiner theoretischen Dichte und mit einem unterstöchiometrischen Sauerstoffgehalt, dadurch gekennzeichnet, daß das Target eine Kristallphase aufweist, die mit einem Gewichtsanteil von mindestens 90 % als Mischkristall von Indiumoxid und Zinnoxid ausgebildet ist, und die eine mittlere Korngröße zwischen 2 µm und 20 µm aufweist.

2. Target nach Anspruch 1, dadurch gekennzeichnet, daß die Kristallphase mit einem Gewichtsanteil von mindestens 97 % als Mischkristall ausgebildet ist.

3. Target nach Anspruch 1 oder 2, dadurch gekennzeichnet, daß die Mischkristallphase im Kristallgitter von Indiumoxid vorliegt.

4. Target nach einem der Ansprüche 1 bis 3, dadurch gekennzeichnet, daß die Mischkristallphase durch Heißpressen oder isostatisches Heißpressen von Indiumoxid/Zinnoxid-Pulverteilchen hergestellt ist, die einen von außen nach innen abnehmenden Sauerstoffgehalt aufweisen.

5. Target nach Anspruch 4, dadurch gekennzeichnet, daß die Pulverteilchen eine oxidische Außenhaut aufweisen, die einen Kern aus metallischer Phase umschließt.

6. Target nach einem der vorhergehenden Ansprüche, dadurch gekennzeichnet, daß die Pulverteilchen eine metallische Phase aufweisen, deren Indiumgehalt mindestens 50 Gew.-% beträgt.

7. Verfahren zur Herstellung eines Targets für die Kathodenzerstäubung durch Einsatz eines Ausgangspulvers aus Indiumoxid und Zinnoxid und Verdichten des Ausgangspulvers durch Heißpressen oder isostatisches Heißpressen, dadurch gekennzeichnet, daß das Ausgangspulver durch Oxidation von fein verteiltem Indium-Zinn-Metall erzeugt wird und daß das Ausgangspulver eine mittlere Teilchengröße im Bereich von 2 µm bis 20 µm aufweist.

8. Verfahren nach Anspruch 7, dadurch gekennzeichnet, daß das Ausgangspulver durch Zerstäuben einer Indium-Zinn-Metallschmelze unter oxidierender Atmosphäre erzeugt wird.

9. Verfahren nach Anspruch 7 oder 8, dadurch gekennzeichnet, daß ein Ausgangspulver eingesetzt wird, das eine metallische Phase aufweist, deren Indiumgehalt mindestens 50 Gew.-%, vorzugsweise um 90 Gew.-% beträgt.

10. Verfahren nach Anspruch 7, dadurch gekennzeichnet, daß die oxidische Phase der Pulverteilchen des Ausgangspulvers eine Mischkristallphase aufweist.

11. Verfahren nach Anspruch 10, dadurch gekennzeichnet, daß die Mischkristallphase im Kristallgitter von Indiumoxid vorliegt.

12. Verfahren nach Ansprüche 10 oder 11, dadurch gekennzeichnet, daß der Anteil der Mischkristallphase mindestens 90 Vol-%, vorzugsweise mindestens 97 Vol-% vom Gesamtvolumen des Ausgangspulvers beträgt.

## Claims

1. Target for cathode sputtering, based on hot-pressed or isostatically hot-pressed indium oxide/tin oxide powder having a density of at least 95% of its theoretical density and having a substoichiometric oxygen content, characterized in that the target has a crystal phase which is formed with at least 90% by weight as a solid solution of indium oxide and tin oxide, and which has a mean particle size between 2 µm and 20 µm.

2. Target according to Claim 1, characterized in that the crystal phase is formed with at least 97% by weight as the solid solution.

3. Target according to Claim 1 or 2, characterized in that the solid solution phase is present in the crystal lattice of indium oxide.

4. Target according to any of Claims 1 to 3, characterized in that the solid solution phase is prepared by hot pressing or hot isostatic pressing of indium oxide/tin oxide powder particles which have an oxygen content decreasing from the outside inwards.

5. Target according to Claim 4, characterized in that the powder particles have an oxidic outer skin which encloses a core of metallic phase.

6. Target according to any of the preceding Claims, characterized in that the powder particles have a metallic phase whose indium content is at least 50% by weight.

7. Process for the preparation of a target for cathode sputtering by using a starting powder comprising indium oxide and tin oxide and compacting the starting powder by hot pressing or hot isostatic pressing, characterized in that the starting powder is produced by oxidation of finely divided indium-tin metal and that the starting powder has a mean particle size in the range from 2 µm to 20 µm.

8. Process according to Claim 7, characterized in that the starting powder is produced by sputtering an indium-tin metal melt under an oxidizing atmosphere.

9. Process according to Claim 7 or 8, characterized in that a starting powder which has a metallic phase whose indium content is at least 50% by weight, preferably about 90% by weight, is used.

10. Process according to Claim 7, characterized in that the oxidic phase of the powder particles of the starting powder has a solid solution phase.

11. Process according to Claim 10, characterized in that the solid solution phase is present in the crystal lattice of indium oxide.

12. Process according to Claim 10 or 11, characterized in that the amount of the solid solution phase is at least 90% by volume, preferably at least 97% by volume, of the total volume of the starting powder.

## Revendications

1. Cible pour la pulvérisation cathodique à base de poudre d'oxyde d'indium/d'oxyde d'étain pressée à chaud ou pressée à chaud par voie isostatique, présentant une densité d'au moins 95 % de sa densité théorique et comportant de l'oxygène en teneur sous-stoechiométrique, caractérisée en ce que la cible présente une phase cristalline qui est réalisée avec une proportion pondérale d'au moins 90 % en tant que cristal mixte d'oxyde d'indium et d'oxyde d'étain, et qui présente une granulométrie moyenne entre 2 µm et 20 µm.

2. Cible selon la revendication 1, caractérisée en ce que la phase cristalline est réalisée avec une proportion pondérale d'au moins 97 % en tant que cristal mixte.

3. Cible selon l'une ou l'autre des revendications 1 et 2, caractérisée en ce que la phase cristalline mixte se présente dans le réseau cristallin d'oxyde d'indium.

4. Cible selon l'une quelconque des revendications 1 à 3, caractérisée en ce que la phase cristalline mixte est réalisée par pressage à chaud ou par pressage à chaud isostatique de particules de poudre d'oxyde d'indium/d'oxyde d'étain qui présentent une teneur en oxygène qui diminue depuis l'extérieur vers l'intérieur.

5. Cible selon la revendication 4, caractérisée en ce que les particules de poudre présentent une peau extérieure d'oxyde qui entoure un noyau de phase métallique.

6. Cible selon l'une quelconque des revendications précédentes, caractérisée en ce que les particules de poudre présentent une phase métallique dont la teneur en indium s'élève au moins à 50 % en poids.

7. Procédé pour produire une cible pour la pulvérisation cathodique par utilisation d'une poudre de départ en oxyde d'indium et en oxyde d'étain et par compression de la poudre de départ par pressage à chaud ou par pressage à chaud isostatique, caractérisé en ce que la poudre de départ est produite par oxydation d'indium et d'étain métalliques finement répartis, et en ce que la poudre de départ présente une granulométrie moyenne dans la plage de 2 µm à 20 µm.

8. Procédé selon la revendication 7, caractérisé en ce que la poudre de départ est produite par pulvérisation d'une fonte métallique indium/étain sous une atmosphère oxydante.

9. Procédé selon l'une ou l'autre des revendications 7 et 8, caractérisé en ce que l'on utilise une poudre de départ qui présente une phase métallique dont la teneur en indium est d'au moins 50 % en poids, de préférence de 90 % en poids.

10. Procédé selon la revendication 7, caractérisé en ce que la phase oxydée des particules de la poudre de départ présente une phase cristalline mixte.

11. Procédé selon la revendication 10, caractérisé en ce que la phase cristalline mixte se présente dans le réseau cristallin d'oxyde d'indium.

12. Procédé selon l'une ou l'autre des revendications 10 et 11, caractérisé en ce que la proportion de la phase cristalline mixte est d'au moins 90 % en volume, de préférence de 97 % en volume du volume total de la poudre de départ.
